Europäisches Patentamt

(19) European Patent Office

Office européen des brevets

(11) Numéro de publication : **0 093 804**
**B1**

(12) **FASCICULE DE BREVET EUROPÉEN**

(45) Date de publication du fascicule du brevet :
**10.09.86**

(21) Numéro de dépôt : **82200580.7**

(22) Date de dépôt : **12.05.82**

(51) Int. Cl.⁴ : **F 42 C 11/06**

(54) Circuit électronique perfectionné pour l'allumage d'un détonateur.

(43) Date de publication de la demande :
**16.11.83 Bulletin 83/46**

(45) Mention de la délivrance du brevet :
**10.09.86 Bulletin 86/37**

(84) Etats contractants désignés :
**AT BE CH DE FR GB IT LI NL SE**

(56) Documents cités :
**EP-A- 0 008 835**
**US-A- 3 299 288**

(73) Titulaire : **"s.a. PRB", Société anonyme**
**Avenue de Broqueville 12**
**B-1150 Bruxelles (BE)**

(72) Inventeur : **Orlandi, Robert Geo**
**10, chemin de la Rochelle**
**CH-1008 Prilly (CH)**

(74) Mandataire : **Donné, Eddy**
**M.F.J.Bockstael Arenbergstraat 13**
**B-2000 Anvers (BE)**

## Description

L'invention concerne un circuit électronique perfectionné pour l'allumage d'un détonateur.

On connaît un circuit de ce genre comprenant un générateur pour charger un premier et un second condensateurs connectés en série, ledit premier condensateur étant connecté en série avec un contacteur, une amorce et un élément semi-conducteur à conductibilité commandée, et des moyens pour stabiliser la tension de l'un desdits condensateurs et pour empêcher l'allumage de l'amorce pendant un temps prédéterminé (DE-A-1 948 382).

Afin de rendre un tel circuit plus fiable et moins onéreux, on a proposé de le modifier en sorte que lesdits moyens comprennent un premier diviseur de tension branché en parallèle avec la connexion en série desdits premier et second condensateurs et dudit contacteur, l'électrode de commande dudit élément semi-conducteur étant reliée au point intermédiaire dudit premier diviseur de tension comprenant un transistor dont la base est connectée au point intermédiaire d'un second diviseur de tension connecté en parallèle avec ledit second condensateur qui a une valeur plusieurs fois plus grande que celle du premier condensateur (voir le document EP-A-0 008 835).

On obtenait ainsi que lesdits moyens non seulement stabilisent la tension du second condensateur sans utiliser une diode Zener mais empêchent l'allumage de l'amorce pendant un temps prédéterminé après la charge des condensateurs.

Il est évident que lesdits moyens pour empêcher l'allumage de l'amorce pendant un temps prédéterminé peuvent être basés sur n'importe quel dispositif de temporisation, par exemple un dispositif tel que révélé par le brevet américain n° 3 299 288. Néanmoins le remplacement du dispositif de temporisation, par exemple par celui dudit brevet américain, n'offre pas une meilleure sécurité comme déjà obtenu dans le circuit de l'application selon EP-A-0 008 835.

Le but de la présente invention est d'améliorer encore les circuits du type tel que décrit au document EP-A-0 008 835 en y introduisant une sécurité de bouche efficace ainsi qu'une sécurité empêchant définitivement la mise à feu au cas où le contacteur d'allumage serait fermé durant tout le temps de sécurité de bouche, cette neutralisation ne s'appliquant toutefois pas en cas de fermeture(s) fugace(s) pendant ledit temps de sécurité. Telles fermetures fugaces sont généralement dues aux forces parasites qui sont induites lors de la phase initiale de vol d'un projectile.

A cet effet, par rapport au document EP-A-0 008 835 décrivant un circuit du type comprenant un générateur destiné à fournir une tension à deux condensateurs montés en série, dont le premier sert à fournir, via un contacteur de commande d'allumage, de l'énergie à une amorce et dont le deuxième sert à la commande, via un dispositif de temporisation et l'une des deux entrées d'un circuit de type porte ET, d'un interrupteur électronique inséré dans l'alimentation de ladite amorce, l'invention se caractérise en ce qu'entre l'autre entrée dudit circuit et l'alimentation de l'amorce provenant dudit premier condensateur est interposé un troisième condensateur.

Le dessin annexé représente, schématiquement et à titre d'exemple, une forme d'exécution du circuit, objet de l'invention.

Dans ce dessin,

la figure 1 illustre le principe général de cette forme d'exécution, tandis que

la figure 2 en montre une réalisation détaillée.

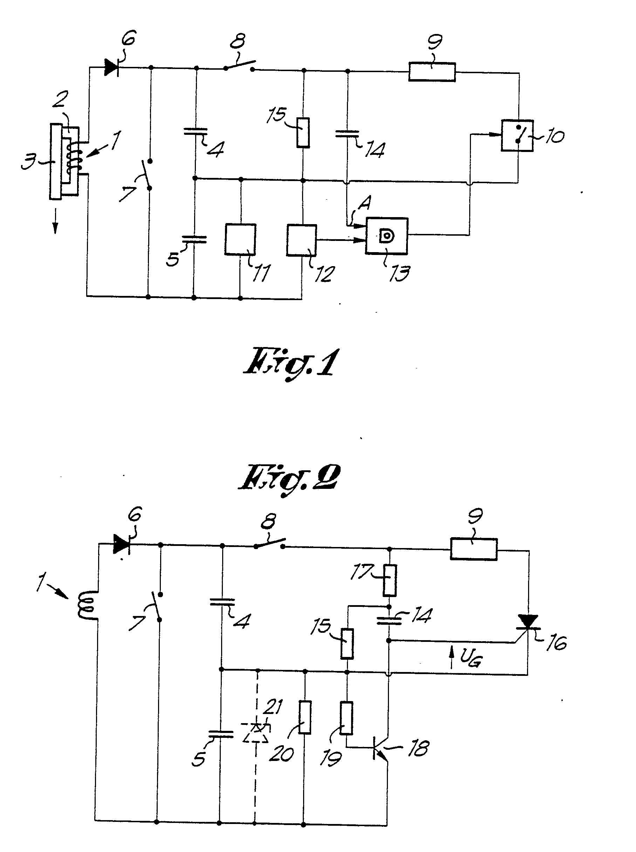

En référence à la figure 1, le circuit comprend un système générateur bien connu, formé par un enroulement 1 disposé autour d'un noyau magnétique dont une partie 2 est en fer doux et une partie 3 est constituée par un aimant permanent. Ce dernier est destiné à être séparé de la partie 2 lors du départ du coup. Ce déplacement est généralement obtenu simplement par effet d'inertie et l'éloignement de l'aimant permanent 3 provoque une variation brusque du flux magnétique dans l'enroulement 1, ce qui induit une tension électrique utilisée pour charger deux condensateurs 4 et 5 branchés en série.

Une diode 6 évite qu'après avoir été chargés, les condensateurs 4 et 5 ne se déchargent dans l'enroulement 1. Un interrupteur 7, lié mécaniquement à la partie mobile du système générateur, court-circuite, avant le départ du coup, le condensateur 4 ou les deux condensateurs 4 et 5 pour annihiler toutes charges rémanentes ou induites par des champs électriques parasites.

Le condensateur 4 alimente en série un contacteur 8 de commande de l'allumage, une amorce 9 et un interrupteur électronique 10.

Le condensateur 5 est relié à un dispositif de stabilisation 11 de sa tension et à un dispositif de temporisation 12. Ce dernier agit sur un circuit 13 travaillant de façon analogue à une porte ET et fournissant le signal de commande de fermeture de l'interrupteur électronique 10.

Lors du départ du coup, les deux condensateurs 4 et 5 sont chargés, le condensateur 4 étant destiné à fournir l'énergie nécessaire à l'allumage de l'amorce 9. Le condensateur 5 alimente le dispositif temporisateur 12 qui empêche, par l'intermédiaire du circuit 13, qu'un signal puisse fermer l'interrupteur 10 pendant une certaine durée après la charge des condensateurs. Cette durée peut être de l'ordre de 100 ms par exemple et permet d'obtenir la sécurité de bouche. La temporisation obtenue par le circuit 12 est constante, grâce au stabilisateur de tension 11 qui permet d'obtenir une tension de charge du condensateur 5 indépendante de la tension fournie par le générateur. En effet, cette dernière peut varier de façon non négligeable en fonction de l'accélération initiale du projectile et donc de la vitesse de déplacement de l'aimant permanent 3.

Les dispositions décrites jusqu'ici sont connues (EP-A-0 008 835, déjà cité).

Conformément à l'invention, un condensateur 14, dont la capacité est beaucoup plus petite que celle de 4, est placé en série sur l'entrée A de la porte ET 13 en sorte que l'énergie prélevée sur le condensateur 4 en cas de fermeture fugitive du contacteur 8 (généralement lors du départ du coup) soit négligeable et indépendante de la résistance d'entrée de la porte ET. Une résistance 15, dont la valeur est choisie de façon à ne prélever qu'une très faible partie de l'énergie du condensateur 4 durant la fermeture fugitive du contacteur 8, permet de décharger le condensateur 14, afin de rendre à nouveau opérationnelle l'entrée A de la porte ET 13 lorsque le contacteur 8 revient en position ouverte après son action fugitive.

La figure 2 illustre une forme d'exécution particulièrement avantageuse du circuit selon la figure 1. On retrouve l'enroulement 1 du générateur, la diode 6, l'interrupteur 7, les condensateurs 4 et 5, le contacteur 8 et l'amorce 9.

L'interrupteur électronique 10 est constitué par un thyristor 16 dont l'électrode de commande est reliée à un diviseur de tension formé par un réseau 15, 17, 14 et un transistor bipolaire ou MOS 18. Ce diviseur de tension est branché aux bornes des deux condensateurs 4 et 5 en série, en sorte d'obtenir, lors de la conduction de 18, une tension UG négative sur l'électrode de commande du thyristor 16. La base du transistor 18 est commandée, au travers d'une résistance 19, par la tension aux bornes du condensateur 5.

Le circuit fonctionne de la façon suivante : au début de la charge des condensateurs 4 et 5, le transistor 18 devient conducteur, dès que la tension aux bornes du condensateur 5 atteint la valeur voulue (en général 0,6 V), pour amener ce transistor à saturation. A ce moment, la tension sur le condensateur 4 est donc beaucoup trop faible pour permettre la mise à feu de l'amorce 9 qui est en principe d'un type à éclateur. Dès que le transistor 18 conduit, l'électrode de commande UG du thyristor 16 est rendue négative par rapport à sa cathode, ce qui exclut toute possibilité de conduction de ce thyristor.

La sécurité de bouche est donnée par la décharge du condensateur 5 dans la combinaison de résistances 19, 20, et le transistor 18 jusqu'au moment où le courant de base de ce dernier devient trop faible pour le maintenir à l'état conducteur. Dès ce moment, l'électrode de commande du thyristor 16 peut recevoir le potentiel positif du condensateur 4 qui est transmis par le condensateur 14 et la résistance 17. Cette dernière est choisie en sorte que le courant la traversant soit suffisant pour enclencher le thyristor 16.

En cas de fermeture fugitive du contacteur 8 durant le temps de sécurité, le condensateur 14 se charge au travers de 17 et 18. Le potentiel UG de gâchette du thyristor 16 est maintenu négatif par la conduction du transistor 18. Lors de la réouverture du contacteur 8, le condensateur 14 se décharge dans le réseau 15, 18.

Le circuit décrit permet d'obtenir à bon marché la stabilisation de la tension du condensateur 5, grâce à l'effet Zener que l'on constate entre la cathode et l'électrode de commande de certains types de thyristor. En effet, dès que la tension positive de la cathode par rapport à l'électrode de commande dépasse une valeur déterminée, de l'ordre de 10 V, on constate le passage d'un courant, ce qui donne un courant de décharge du condensateur 5 à travers le circuit constitué par la cathode de 16, son électrode de commande et le transistor 18. De cette façon, la tension maximum de 5 est limitée, de sorte que son temps de décharge jusqu'au moment où 18 devient non conducteur est constant. Une diode Zener 21 peut également être utilisée si le thyristor ne présente pas d'effet Zener entre grille et cathode.

Dans le schéma de la figure 2, il y a lieu de remarquer que la tension de commande du transistor 18 est bien inférieure à celle nécessaire au fonctionnement de l'amorce 9, de sorte que l'on peut avantageusement donner au condensateur 5 une capacité plusieurs fois plus grande que celle du condensateur 4.

**Revendications**

1. Circuit électronique perfectionné pour l'allumage d'un détonateur du type comprenant un générateur (1-3) destiné à fournir une tension à deux condensateurs (4-5) montés en série, dont le premier (4) sert à fournir, via un contacteur de commande d'allumage (8), de l'énergie à une amorce (9) et dont le deuxième (5) sert à la commande, via un dispositif de temporisation (12) et l'une des deux entrées d'un circuit de type porte ET (13), d'un interrupteur électronique (10) inséré dans l'alimentation de ladite amorce (9), caractérisé en ce qu'entre l'autre entrée (A) dudit circuit (13) et l'alimentation de l'amorce provenant dudit premier condensateur (4) est interposé un troisième condensateur (14).

2. Circuit électronique selon la revendication 1, caractérisé en ce que la capacité du deuxième condensateur (5) est un multiple de celle du premier condensateur (4).

3. Circuit électronique selon la revendication 2, caractérisé en ce que la capacité dudit troisième condensateur (14) est une fraction de celle dudit premier condensateur (4).

4. Circuit électronique selon la revendication 1, dans lequel ledit circuit type porte ET (13) est un transistor (18), caractérisé en ce que trois résistances (19, 15, 17) sont connectées en série à la base dudit transistor (18), la troisième (17) de ces résistances étant montée également en série avec ledit troisième condensateur (14).

5. Circuit électronique selon la revendication 4, dans lequel ledit interrupteur électronique (10) est un thyristor (16), caractérisé en ce que l'électrode de commande de ce dernier est destinée à recevoir le potentiel positif dudit premier condensateur (4) — via ledit contacteur de commande d'allumage (8), ladite troisième résistance (17) et ledit troisième condensateur (14) — dès l'instant où ledit transistor (18) cesse d'être conducteur.

## Claims

1. A perfected electronic circuit for the ignition of a detonator of the type comprising a generator (1-3) meant to supply a tension to two capacitors (4-5) connected in series of which the first capacitor (4) is used to supply through an ignition control switch (8) the energy to a detonator (9) and the second capacitor (5) is used to control by way of a delaying device (12) and one of the two gates of an AND-gate type circuit (13) of an electronic switch (10) inserted in the feeding system of the said detonator (9), characterized thereby that between the other gate (A) of said circuit (13) and the feeding of the detonator (13) coming from the said first capacitor (4) a third capacitor (14) is connected.

2. An electronic circuit according to claim 1, characterized thereby that the capacity of the second capacitor (5) is a multiple of that of the second capacitor (4).

3. An electronic circuit according to claim 2, characterized thereby that the capacity of said third capacitor (14) is a fraction of that of said first capacitor (4).

4. An electronic circuit according to claim 1, in which the said AND-gate type circuit (13) is a transistor (18) characterized thereby that three resistances (19, 15, 17) are connected in series with the base of said transistor (18), the third (17) of these resistances being also connected in series with the said third capacitor (14).

5. An electronic circuit according to claim 4, in which the said electronic switch (10) is a thyristor (16) characterized thereby that the control electrode of the latter is meant to receive a positive potential from the said first capacitor (4) — through the said ignition control switch (8), the said third resistance (17) and the said third capacitor (14) — from the moment the said transistor (18) will cease being conductive.

## Patentansprüche

1. Perfektionierte elektronische Schaltung zur Zündung eines Zünders der Type mit einem Generator (1-3) bestimmt zur Lieferung einer Spannriung an zwei Kondensatoren (4-5) die in Serie geschaltet sind, wovon der erste (4) dient zur Energielieferung, über einen Zündungskontaktgeber (8) an eine Zündkapsel (9) und wovon der zweite (5) dient zur Steuerung, über eine Verzögerungsvorrichtung (12) und einen dezwei Eingänge einer Schaltung der UND-Gattertype (13) eines elektronischen Schalters (10), eingebaut in der Stromversorgung der besagten Zündkapsel (9) dadurch gekennzeichnet daß zwischen dem anderen Eingang (A) der besagten Schaltung (13) und der Stromversorgung der Zündkapsel vom besagten ersten Kondensator (4) herkommend einen dritten Kondensator (14) zwischengebaut wurde.

2. Elektronische Schaltung laut Anspruch 1, dadurch gekennzeichnet daß die Kapazität des zweiten Kondensators (5) ein Vielfaches ist von der des zweiten Kondensators.

3. Elektronische Schaltung laut Anspruch 1, dadurch gekennzeichnet daß die Kapazität des besagten dritten Kondensators (14) ein Bruchteil ist dieser des besagten ersten Kondensators (4).

4. Elektronische Schaltung laut Anspruch 1, in der die besagte Schaltung der UND-Gattertype (13) ein Transistor (18) ist dadurch gekennzeichnet daß drei Widerstände (19, 15, 17) in Serie geschaltet sind mit der Basis des besagten Transistors (18) wobei der dritte dieser Widerstände gleichweise in Serie geschaltet ist mit dem dritten Kondensator (14).

5. Elektronische Schaltung laut Anspruch 4, in der der besagte elektronische Schalter (10) ein Thyristor (16) ist, dadurch gekennzeichnet daß die Steuerelektrod dieses letzteren bestimmt ist ein positives Potential zu erhalten vom besagten ersten Kondensator (4) — über den besagten Zündungssteuerschalter (8) den besagten dritten Widerstand (17) und den besagten dritten Kondensator (14) — vom Moment an daß besagter Transistor (18) aufhört leitend zu sein.

**Fig.1**

**Fig.2**